# EUROPEAN PATENT SPECIFICATION

(11) **EP 2 143 209 B1**
(45) Date of publication and mention of the grant of the patent: **15.08.2018**
(21) Application number: 08746721.3
(22) Date of filing: 23.04.2008
(51) Int. Cl.: H04B 1/02, H03F 1/02, H03F 1/32, H03F 3/24, H04B 1/04, H04B 1/00

(54) **DIGITAL HYBRID MODE POWER AMPLIFIER SYSTEM**
DIGITAL-HYBRIDMODUS-LEISTUNGSVERSTÄRKERSYSTEM
SYSTÈME D'AMPLIFICATION DE PUISSANCE EN MODE HYBRIDE NUMÉRIQUE

(30) Priority: 23.04.2007 US 925603 P; 23.04.2007 US 925577 P; 30.04.2007 US 799239; 30.08.2007 US 969127 P; 30.08.2007 US 969131 P; 07.12.2007 US 12416; 20.12.2007 US 962025; 20.12.2007 US 961969; 28.01.2008 US 21241; 31.03.2008 US 41164
(43) Date of publication of application: 13.01.2010
(73) Proprietor: Dali Systems Co. Ltd, George Town, Grand Cayman (KY)
(72) Inventor: KIM, Wan-Jong, Coquitlam BC V3K2T3 (KR); CHO, Kyoung-joon, Coquitlam BC V3K6R9 (CA); STAPLETON, Shawn, Patrick, Burnaby, BC, V5A 4C6 (CA); KIM, Jong-Heon, Seoul 140-120 (KR); YANG, Dali, Mountain View, CA 94040 (US)
(74) Representative: Freeman, Jacqueline Carol
(86) International application number: PCT/US2008/061355
(87) International publication number: WO 2008/154077

(56) References cited:
- US-A- 5 937 011
- US-A- 6 141 390
- US-A1- 2004 105 509
- US-A1- 2004 212 428
- US-A1- 2005 059 360
- US-A1- 2005 059 360
- US-B1- 6 751 447
- US-B1- 7 106 806
- US-B2- 6 552 609
- US-B2- 6 794 931
- US-B2- 7 068 984

## Description

### RELATED APPLICATIONS

This application discloses similar subject matter to, and/or is related by common priority claims, to US applications which resulted in the following US Patents: US 6 985 704, US 8 326 238, US 8 064 850, US 8 380 143, US 8 811 917, US 8 472 897, US 8 149 950.

### FIELD OF THE INVENTION

The present invention generally relates to wireless communication systems using complex modulation techniques. More specifically, the present invention relates to power amplifier systems for wireless communications.

### BACKGROUND OF THE INVENTION

A wideband mobile communication system using complex modulation techniques, such as wideband code division access (WCDMA) and orthogonal frequency division multiplexing (OFDM), has large peak-to- average power ratio (PAPR) specifications and hence requires highly linear power amplifiers for its RF transmissions. The conventional feedforward linear power amplifier (FFLPA) has been widely utilized due to its excellent linearity performance in spite of poor power efficiency.

Conventional FFLPAs are mainly based on the principle of error subtraction and power-matching with dedicated hardware circuitries to realize non-linear corrections to PA. These approaches must use an auxiliary PA and complicated hardware circuitries to match exactly the transmitted power-balance, time-delay and errors generated by the main PA. After a perfect matching is obtained, the non-linear distortion errors from the main PA can then be canceled by those distortion errors from the auxiliary PA. Due to the complexities of the nonlinear predistortion circuits, which among other things involve many variables and parameters, FFLPAs require significant fine tuning and other calibration efforts. In addition, such traditional FFLPA schemes are also vulnerable to fluctuating environmental conditions, such as temperature and humidity changes, since perfect alignment of the main PA's signal and that of the auxiliary PA are vital. As a result, traditional predistortion schemes are costly to implement and are limited in their predistortion accuracy and stability in a commercial wireless system environment.

In order to overcome the FFLPA's poor efficiency, digital baseband predistortion (PD) has been demonstrated due to the recent advances in digital signal processing (DSP) technology. In addition, Doherty power amplifiers (DPA) have also been applied to these linearization systems to improve power efficiency. However, there is still a demand for higher performance of the power amplifier such as more linearity and better efficiency with less expensive architecture.

Conventional DSP-based PD schemes utilize digital microprocessors to compute, calculate and correct the PA's nonlinearities: they perform fast tracking and adjustments of signals in the PA system. However, conventional DSP-based PD schemes are challenged by variations of the linearity performance of the amplifier due to the environment changing such as temperature and the asymmetric distortions of the output signal of the PA resulting from memory effects. All these variations and distortions have to be compensated for. Since conventional PD algorithms are based on a wideband feedback signal, they require a power-intensive and expensive high speed analog-to-digital converter (ADC) in order to capture necessary information, if at all possible, for processing. In addition, time-synchronizations are also inevitable in order to capture an error signal between a reference signal and a distorted signal. This time-matching process may result in small synchronization errors which can further affect conventional PD schemes' linearization performance.

Moreover, conventional PD schemes necessitate coded in-phase (I) and quadrature (Q) channel signals in the baseband as the required ideal or reference signals. As a result, conventional PD schemes are often standard or modulation specific and must be closely tailored to each baseband system. Therefore, in order to deploy conventional PD schemes into base-stations, the PD engines must be embedded into the baseband architecture of base-stations. This embedment is a practical implementation challenge since it is frequently inconvenient or impossible to modify the baseband architectures of existing base-stations or base-station designs. Once the PD scheme is set up for a specific base-station design, it is often not reconfigurable and hence not upgradeable to future changes in standards or modulations. Furthermore, since traditional PD approaches require baseband I-Q signal sources to operate, they are inapplicable to certain RF systems that do not possess any baseband I-Q signal sources, such as repeater and indoor signal coverage sub-systems.

US 2004105509 (A1) describes a forward link transmitter in a sectored cell which includes a baseband processor having traditional baseband signal digital processing circuitry in addition to including a digital hybrid matrix (vector and delay compensated transformation module) whose phase and amplitude (vector) and delay may be adjusted to compensate for downstream errors that are introduced and detected by a feedback circuit. A baseband processor, by monitoring an output of an analog hybrid matrix producing modulated and amplified radio frequency (RF) signals just prior to propagation from an antenna, can determine errors produced by the analog circuitry including the analog hybrid matrix and may compensate for the same by introducing an amplitude, phase and delay adjustment (in the digital domain) into output digital waveform signals to compensate for the error introduced downstream to the baseband processor.

US 6 751 447 (B1) discloses a pre-distortion correction circuit for use in an RF transmitter having a transmit path for receiving and amplifying an RF input signal. The pre-distortion correction circuit modifies distortion in the RF output signal caused by an RF power amplifier in the transmit path. The pre-distortion circuit comprises feedback circuitry coupled to an output of the transmit path for demodulating and digitizing the distorted RF output signal to thereby produce a first demodulated digital output signal, and a pre-distortion calculation controller coupled to the feedback circuitry for comparing the first demodulated digital output signal to adjacent channel power (ACP) profile data stored in the pre-distortion calculation controller and generating therefrom pre-distortion correction values.

US 7 106 806 (B1) discloses a predistorter comprising an array of band pass filters which divide an input signal into components. Each of the components is manipulated using coefficients retrieved from respective look-up tables. The amplitude of each component is used to retrieve a coefficient from its respective look-up table. The amplitude of each component is then multiplied with its respective retrieved coefficient to generate a predistorted amplitude for that component. The predistorted amplitudes are summed to produce a predistorted input signal to counter the distortion characteristic of a signal handling element.

US 5 937 011 (A) describes a distortion correction technique for use with a high power amplifier (HPA) in a multi-carrier radio signaling system such as a cellular base station. Distortion correction is implemented by making use of a broadband digital composite signal input to the high power amplifier as a reference signal in a form of intermediate frequency (IF) distortion correction circuit. A multichannel synthesizer provides the broadband composite signal to a broadband digital radio which in turn provides an input to the (HPA). A portion of the output signal from the HPA is fed back through a radio frequency (RF) and intermediate frequency (IF) down-conversion stage that uses the same IF and RF local oscillators that were used to generate the input signal to the HPA. This feedback signal is fed to a predistortion processor together with a version of the composite digital signal.

US 2002193085 (A1) describes bandwidth reduction of amplitude and/or phase components of relatively wide bandwidth composite signal. In an exemplary embodiment, an EER amplifier system for CDMA signal amplification includes an amplitude bandwidth reduction module included in an amplitude signal component path and a phase bandwidth reduction module is included in a phase signal component path, for controlling an RF amplifier.

US 2005059360 (A1) describes a radio transmitter for transmitting signals in a predetermined frequency band which has a transmit filter and a compensating filter. The transmit filter filters a signal to be transmitted from the transmitter to suppress the transmission of parts of the signal outside the band. The compensating filter, e.g., operating in the digital domain, filters the signal upstream from the transmit filter, wherein the compensating filter is arranged to alter the signal to counteract at least one of a phase ripple, an amplitude ripple, and a group delay variation of the transmit filter within the band.

### SUMMARY OF THE INVENTION

Accordingly, the present invention has been made in view of the above problems, and it is an object of the present invention to provide a high performance and cost effective method of power amplifier systems with high linearity and high efficiency for wideband communication system applications. The present disclosure enables a power amplifier system to be field reconfigurable and support multi-modulation schemes (modulation agnostic), multi-carriers and multi-channels.

To achieve the above objects, according to the present invention, the technique is generally based on the method of adaptive digital predistortion to linearize a power amplifier in the RF domain.

The invention provides a power amplifier system according to the claims.

Various embodiments of the invention are disclosed. In an embodiment, the combination of crest factor reduction, PD, power efficiency boosting techniques as well as a simple algorithm with spectrum monitoring are utilized within a PA system. In another embodiment, analog quadrature modulator compensation structure is also utilized to enhance performance.

Some embodiments of the present invention are able to monitor the fluctuation of the power amplifier characteristics and to self-adjust by means of a self-adaptation algorithm. One such self-adaptation algorithm presently disclosed is called a multi-directional search (MDS) algorithm, which is implemented in the digital domain.

Applications of the present invention are suitable for use with all wireless base-stations, access points, mobile equipment and wireless
terminals, portable wireless devices, and other wireless communication systems such as microwave and satellite communications.

Appendix I is a glossary of terms used herein, including acronyms.

### THE FIGURES

Further objects and advantages of the present invention can be more fully understood from the following detailed description taken in conjunction with the accompanying drawings in which:
Figure 1 is a block diagram showing the basic form of a digital hybrid mode power amplifier system.
Figure 2 is a block diagram showing a simple digital hybrid mode power amplifier system according to one embodiment of the present invention.
Figure 3 is a block diagram showing polynomial based predistortion in a digital hybrid mode power amplifier system of the present invention.
Figure 4 is a flow chart of the multi-directional search algorithm applied for self-adaptation predistortion in a digital hybrid mode power amplifier system of the present invention.
Figure 5 is a block diagram showing a digital hybrid mode power amplifier system implemented with optional or alternative multi-channel digital input, DQM and UPC-based clipping restoration path according to another embodiment of the present invention.
Figure 6 is a block diagram showing a digital hybrid mode power amplifier system implemented with DQM according to another embodiment of the present invention.
Figure 7 is a block diagram showing a digital hybrid mode power amplifier system implemented with AQM according to another embodiment of the present invention.
Figure 8 is a block diagram showing a digital hybrid mode power amplifier system implemented with DUC and UPC-based clipping error restoration path according to another embodiment of the present invention.
Figure 9 is a block diagram showing a digital hybrid mode power amplifier system implemented with AQM and AQM-based clipping error restoration path according to another embodiment of the present invention.
Figure 10 is a block diagram showing the analog quadrature modulator compensation structure.

### DETAILED DESCRIPTION OF THE INVENTION

The present invention is a novel RF-in/RF-out PA system that utilizes an adaptive digital predistortion algorithm. The present invention is a hybrid system of digital and analog modules. The interplay of the digital and analog modules of the hybrid system both linearize the spectral regrowth and enhance the power efficiency of the PA while maintaining or increasing the wide bandwidth. The present invention, therefore, achieves higher efficiency and higher linearity for wideband complex modulation carriers.

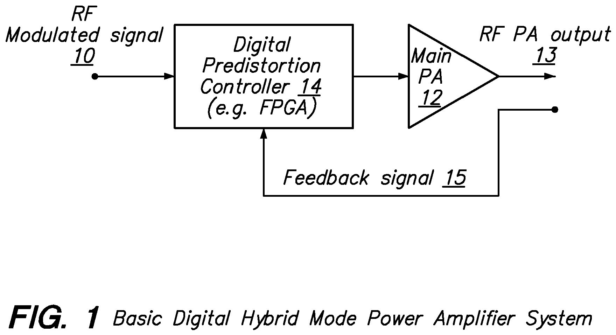

Figure 1 is a high level block diagram showing the basic system architecture which can be thought of, at least for some embodiments, as comprising digital and analog modules and a feedback path. The digital module is the digital predistortion controller 14 which comprises the PD algorithm, other auxiliary DSP algorithms, and related digital circuitries. The analog module is the main power amplifier 12, other auxiliary analog circuitries such as DPA, and related peripheral analog circuitries of the overall system. The present invention is a "black box", plug-and-play type system because it accepts RF modulated signal 10 as its input, and provides a substantially identical but amplified RF signal 13 as its output, therefore, it is RF-in/RF-out. The feedback path essentially provides a representation of the output signal to the predistortion controller 14. The present invention is sometimes referred to as a digital hybrid mode power amplifier (DHMPA) system hereinafter.

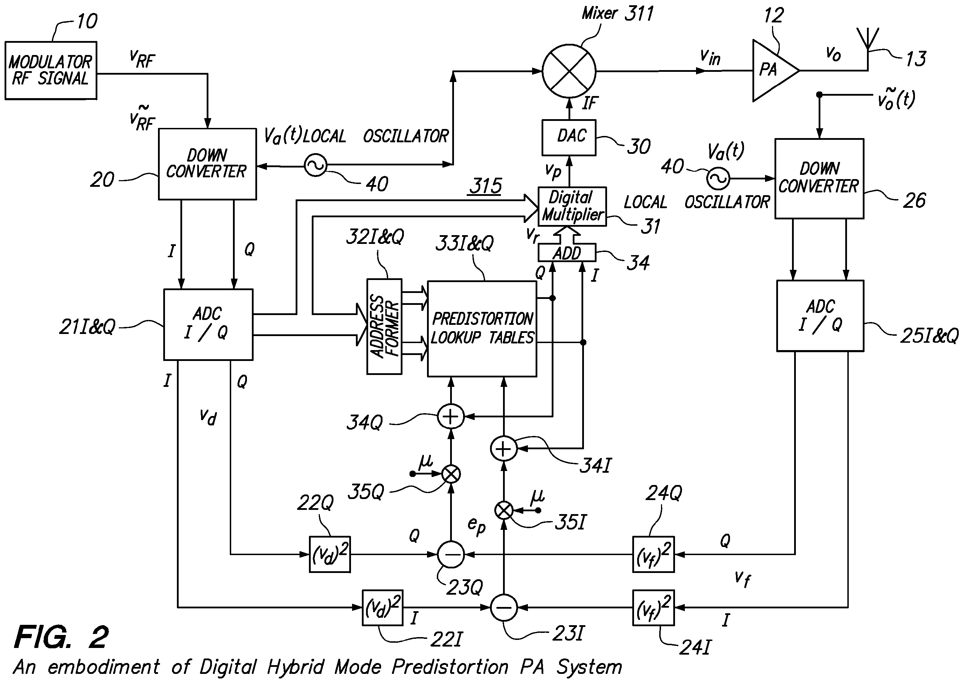

FIG. 2. is a block diagram showing a simple digital hybrid mode power amplifier system according to one embodiment of the present invention. The embodiment in FIG. 2. is very similar to the architecture disclosed in U.S. Patent application US 2007 0241812 A1, except that (i) the RF modulated signal 10, V_{RF}, only goes through the down converter 20, (ii) a digital multiplier 31 is used in lieu of analog multipliers, and (iii) the predistorted signal, V_{P}, is up-converted to IF band, then converted into an analog IF signal by DAC 30, and finally modulated into Vᵢₙ RF signal by mixer 311 before being provided as an input to PA 12 for wireless transmission.

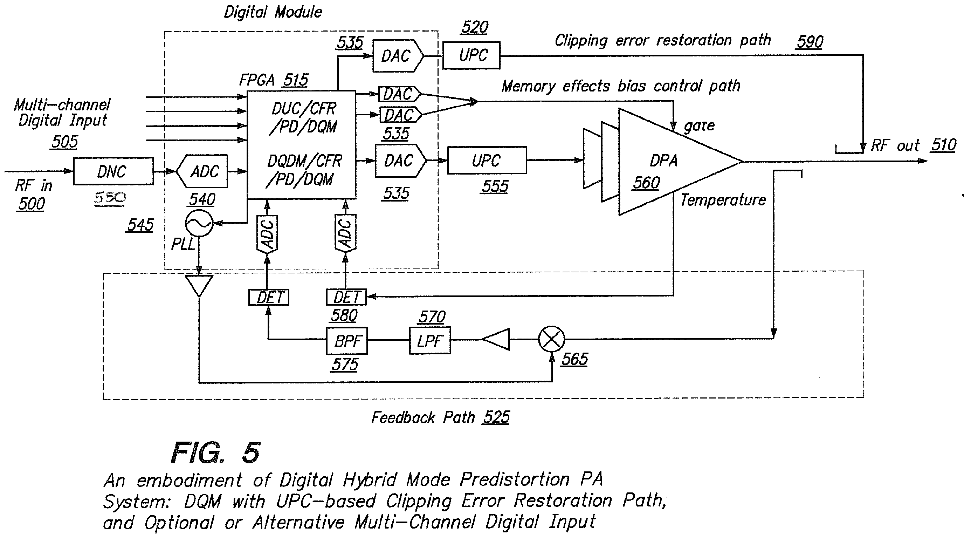

Figures 5-9 are block diagrams showing more sophisticated embodiments of DHMPA system, where like elements are indicated with like numerals. The five embodiments of Figures 5-9 apply crest factor reduction (CFR) prior to the PD with an adaptation algorithm in one digital processor, so as to reduce the PAPR, EVM and ACPR and compensate the memory effects and variation of the linearity due to the temperature changing of the PA. The digital processor can take nearly any form; for convenience, an FPGA implementation is shown as an example, but a general purpose processor is also acceptable in many embodiments. The CFR implemented in the digital module of the embodiments is based on the scaled iterative pulse cancellation presented in patent application US 2008 0265996 A1, filed March 31, 2008, entitled An Efficient Peak Cancellation Method For Reducing The Peak-To-Average Power Ratio In Wideband Communication Systems. The CFR is included to enhance performance and hence optional. The CFR can be removed from the embodiments without affecting the overall functionality.

Figure 5 is a block diagram showing a DHMPA system according to one embodiment of the present invention (the "FIG. 5. System"). The FIG. 5. System has a dual mode of RF 500 and/or multi-carrier digital signal 505 at the input, and an RF signal at the output 510. The dual mode of signal input allows maximum flexibility: RF-in (the "RF-in Mode") or baseband digital-in (the "Baseband-in Mode"). The FIG. 5. System comprises three key portions: a reconfigurable digital (hereinafter referred as "FPGA-based Digital") module 515, a power amplifier module 520 and a feedback path 525.

The FPGA-based Digital part comprises a digital processor 515 (e.g. FPGA), digital-to-analog converters 535 (DACs), analog- to-digital converters 540 (ADCs), and a phase-locked loop (PLL) 545. Since
the FIG. 5 System has a dual input mode, the digital processor has two paths of signal processing. For the RF signal input path, the digital processor has implemented a digital quadrature demodulator (DQDM), a CFR, a PD, and a digital quadrature modulator (DQM). For the baseband digital input path, a digital up-converter (DUC), CFR, PD, and a DQM are implemented.

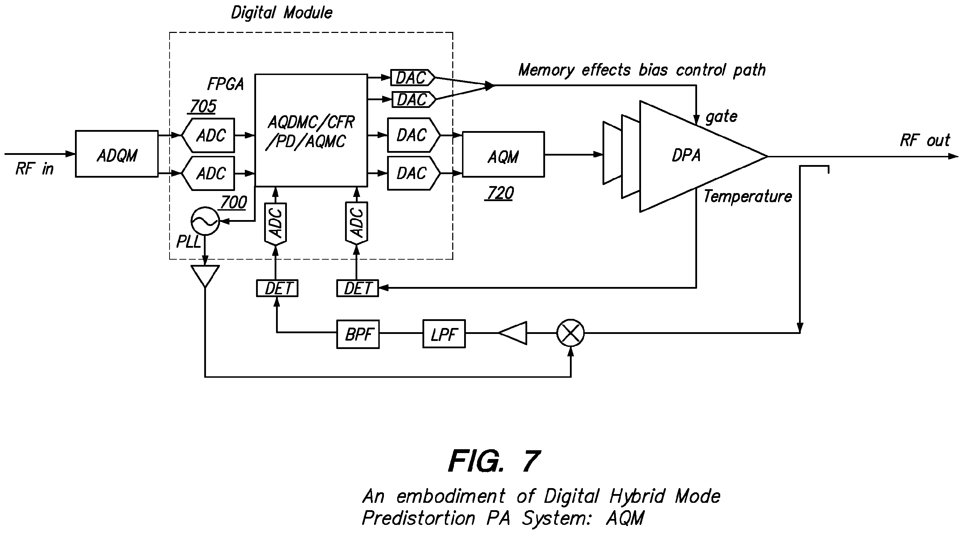

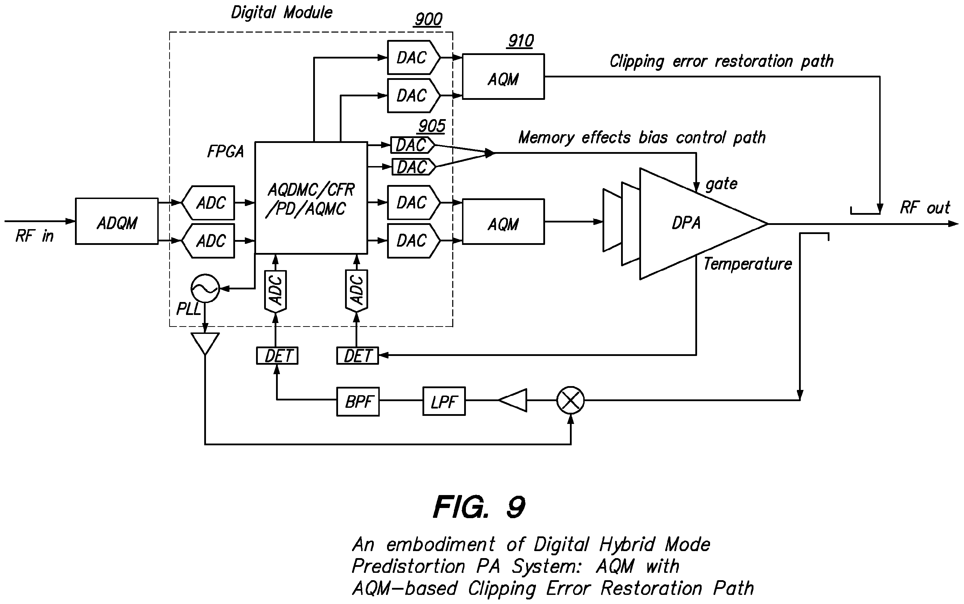

The RF-in Mode of the FIG. 5. System has implemented a down converter (DNC) 550 prior to the FPGA-based Digital part and an ADC 540 prior to the FPGA. An analog down converted signal is provided to the FPGA-based Digital module and converted to a digital signal by the ADC 540. The digitally converted signal is demodulated by the DQDM to generate both real and imaginary signals and then PAPR of the signal is reduced by CFR. The peak reduced signal is predistorted to linearize the amplifier and is passed through a DQM to generate the real signal and then converted to an intermediate frequency (IF) analog signal by a DAC in the FPGA-based Digital part. However, it is not required in all embodiments to implement DQDM and DQM in the FPGA. If, as shown in Figures 7 and 9, a modulator and demodulator will not be used, then two ADC's 700 and 705 prior to the FPGA and two DAC's 710 and 715 behind the FPGA feeding AQM module 720 can be used to generate real and imaginary signals, respectively (the "AQM Implementation"). The embodiment of Figure 9 differs from the embodiment of Figure 7 by virtue of the addition of a clipping error restoration path, indicated by DAC's 900 and 905 together with second AQM logic 910, which feeds to the RF out signal in a manner similar to that shown in Figure 5.

The Baseband-in Mode of FIG. 5. works slightly different from the RF-in Mode. Digital data streams from multi-channels as I-Q signals are coming to the FPGA-based Digital module and are digitally up-converted to digital IF signals by the DUC. From this point onwards, the Baseband-in Mode and RF-in Mode proceeds identically. These IF signals are then passed through the CFR block so as to reduce the signal's PAPR. This PAPR suppressed signal is digitally predistorted in order to pre-compensate for nonlinear distortions of the power amplifier.

In either input mode, the memory effects due to self-heating, bias networks, and frequency dependencies of the active device are compensated by the adaptation algorithm in the PD, as well. The coefficients of the PD are adapted by a narrowband feedback using a simple power detector in the feedback part as opposed to prior art predistortion techniques that use wideband feedback which requires a very high speed ADC. The predistorted signal is passed through a DQM in order to generate the real signal and then converted to an IF analog signal by the DAC 535 as shown. As disclosed above, the DQM is not required to be implemented in the FPGA, or at all, in all embodiments. If the DQM is not used in the FPGA, then the AQM Implementation can be implemented with two DACs to generate real and imaginary signals, respectively. The gate bias voltage 550 of the power amplifier is determined by the adaptation algorithm and then adjusted through the DACs 535 in order to stabilize the linearity fluctuations due to the temperature changes in the power amplifier. The PLL sweeps the local oscillation signal for the feedback part in order to, first, find the channel locations and then detect the adjacent channel power level or the adjacent channel power ratio (ACPR).

The power amplifier part comprises a UPC for a real signal (such as illustrated in the embodiments shown in Figures 5, 6, and 8), or an AQM for real and complex signals (such as depicted in the embodiments shown in Figures 7 and 9) from the FPGA-based Digital module, a high power amplifier with multi-stage drive amplifiers, and a temperature sensor. The predistorted baseband signals are up-converted by the UPC 555 and then amplified by the PA 560. In order to improve the efficiency performance of the DHMPA system, efficiency boosting techniques such as Doherty, Envelope Elimination and Restoration (EER), Envelope Tracking (ET), Envelope Following (EF), and Linear amplification using Nonlinear Components (LINC) can be used, depending upon the embodiment. These power efficiency techniques can be mixed and matched and are optional features to the fundamental DHMPA system. One such Doherty power amplifier technique is presented in commonly assigned U.S. Provisional Patent Application US 60/925,577 (US 7 688 135), filed April 23, 2007, entitled N-Way Doherty Distributed Power Amplifier. To stabilize the linearity performance of the amplifier, the temperature of the amplifier is monitored by the temperature sensor and then the gate bias of the amplifier is controlled by the FPGA-based Digital part.

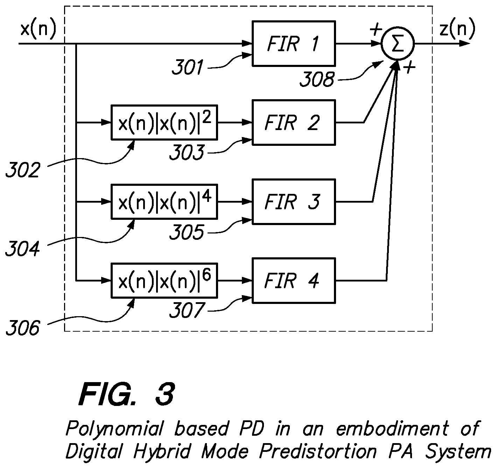

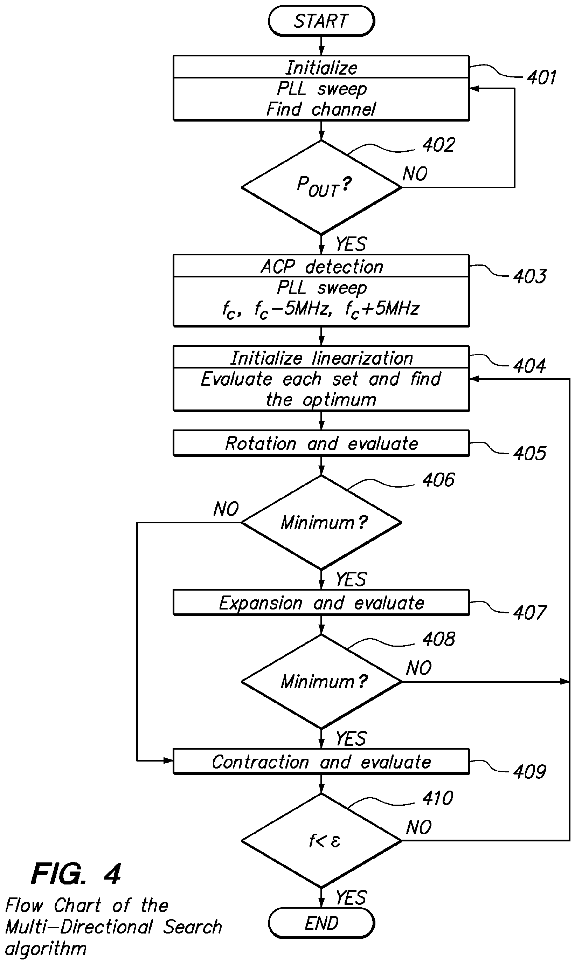

The feedback portion comprises a directional coupler, a mixer, a low pass filter (LPF), gain amplifiers and, a band pass filter (BPF), detectors (DETs). Depending upon the embodiment, these analog components can be mixed and matched with other analog components. Part of the RF output signal of the amplifier is sampled by the directional coupler and then down converted to an IF analog signal by the local oscillation signal in the mixer. The IF analog signal is passing through the LPF, the gain amplifier, and the BPF (e.g., surface acoustic wave filter) which can capture different frequency portions of out-of-band distortions. The output of the BPF is provided to the detector and then to the ADCs of the FPGA-based Digital module in order to determine the dynamic parameters of the PD depending on output power levels and asymmetrical distortions due to the memory effects. In addition, temperature is also detected by the DET 580 to calculate the variation of linearity and then adjust gate bias voltage of the PA. More details of the PD algorithm and self-adaptation feedback algorithm can be appreciated from Figure 3, which shows a polynomial-based predistortion algorithm and from Figure 4, which shows in flow diagram form as steps 401 through 410 a multi-directional search algorithm which can be used in some embodiments of the invention.

In the case of a strict EVM requirement for broadband wireless access such as WiMAX or other OFDM based schemes (EVM < 2.5%), the CFR in the FPGA-based Digital part is only able to achieve a small reduction of the PAPR in order to meet the strict EVM specification. In general circumstances, this means the CFR's power efficiency enhancement capability is limited. In some embodiments of the present invention, a novel technique is included to compensate the in-band distortions from CFR by use of a "Clipping Error Restoration Path" 590, hence maximizing the DHMPA system power efficiency in those strict EVM environments. As noted above, the Clipping Error Restoration Path has an additional DAC 535 in the FPGA-based Digital portion and an extra UPC in the power amplifier part (see FIG. 5. & 8.). The Clipping Error Restoration Path can allow compensation of in-band distortions resulting from the CFR at the output of the power amplifier. Further, any delay mismatch between the main path and the Clipping Error Restoration Path can be aligned using digital delay in the FPGA.

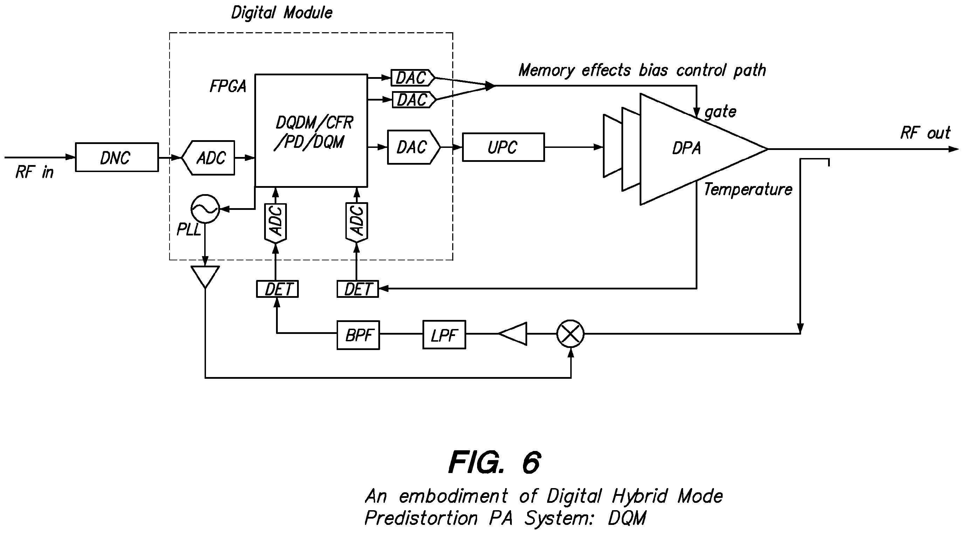

FIG. 6. is a block diagram showing a DHMPA system implemented with DQM according to another embodiment of the present invention (the "FIG. 6 System"). It is identical to FIG. 5 System except that it does not have the Baseband-in Mode and the Clipping Error Restoration Path.

FIG. 7. is a block diagram showing a DHMPA system implemented with AQM according to another embodiment of the present invention (the "FIG. 7 System"). FIG. 7 System is similar to FIG. 6 System except that it has the AQM Implementation option discussed earlier. In addition, the digital processor of FIG. 7 System has implemented an analog quadrature demodulator corrector (AQDMC), a CFR, a PD, and an analog quadrature modulator corrector (AQMC).

In FIG. 7 System, the RF input signal is first down-converted to baseband digital signals, and then digitally up-converted to digital IF signals (-7.5 MHz, -2.5 MHz, 2.5 MHz, 7.5 MHz). If FIG. 7 System has a Baseband-in Mode, then the digital data streams from multi-channels would be digitally up-converted to digital IF signals (-7.5 MHz, -2.5 MHz, 2.5 MHz, 7.5 MHz) directly as they enter the digital processor. The CFR would then reduce the PAPR. The peak reduced signal is predistorted to linearize the DPA and is passing through two DACs for real and imaginary signals and finally through an AQM.

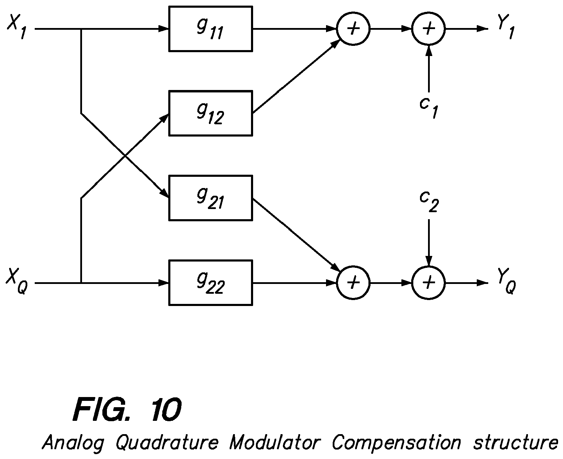

FIG. 10. is a block diagram showing the analog quadrature modulator compensation structure. The input signal is separated input an in-phase component X_{I} and a quadrature component X_{Q}. The analog quadrature modulator compensation structure comprises four real filters {g11, g12, g21, g22} and two DC offset compensation parameters c1 , c2. The DC offsets in the AQM will be compensated by the parameters c1, c2 . The frequency dependence of the AQM will be compensated by the filters {g11, g12, g21, g22}. The order of the real filters is dependent on the level of compensation required. The output signals Y_{I} and Y_{Q} will be presented to the AQM's in-phase and quadrature ports.

The configuration of the power amplifier part and the feedback part of FIG. 7 System are the same as FIG. 6 System.

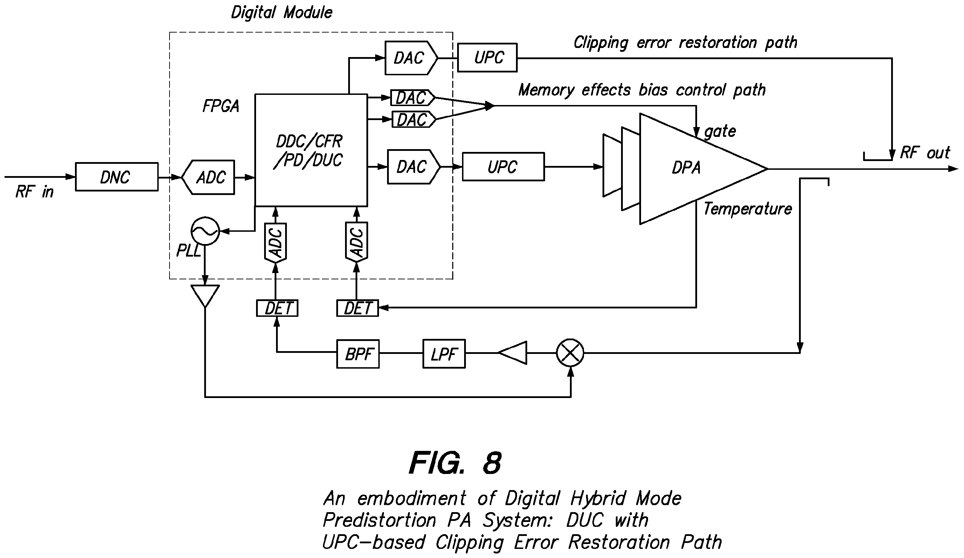

FIG. 8. is a block diagram showing a DHMPA system implemented with DUC and the Clipping Error Restoration Path according to another embodiment of the present invention (the "FIG. 8 System"). FIG. 8 System is similar to FIG. 6 System except that it has the Clipping Error Restoration Path. In addition, the digital processor of FIG. 8 System has implemented a digital down converter (DDC), a CFR, a PD, and DUC.

In FIG. 8 System, the DNC frequency translates the RF signal into a low IF signal. The IF signal is then presented to the ADC whereupon it is digitally down-converted to baseband followed by CFR and PD. The output of the PD is a baseband signal which will then be digitally upconverted to an IF frequency and presented to the DAC. The output of the DAC is then further frequency translated to a RF frequency through the UPC. The configuration of the power amplifier part and the feedback part of FIG. 8 System are the same as FIG. 5 System.

FIG. 9. is a block diagram showing a DHMPA system implemented with AQM and AQM-based Clipping Error Restoration Path according to another embodiment of the present invention (the "FIG. 9 System"). FIG. 9 System is identical to FIG. 7 System except that FIG. 9 System has the Clipping Error Restoration Path. The Clipping Error Restoration Path in FIG. 9 System has two DACs in the FPGA-based Digital part and an AQM in lieu of the UPC in the power amplifier part (see FIG. 5. & 8.).

FIG 3. is a block diagram showing a predistortion (PD) part in the DHMPA system of the present invention. The PD in the present invention generally utilizes an adaptive LUT-based digital predistortion system. More specifically, the PD illustrated in FIG. 3 and in embodiments disclosed from FIG. 5 to FIG. 9 are processed in the digital processor by an adaptive algorithm, presented in U.S. Patent application S.N. 11/961,969 (US 8 149 950), entitled A Method for Baseband Predistortion Linearization in Multi-Channel Wideband Communication Systems. The PD for the DHMPA system in FIG. 3. has multiple finite impulse response (FIR) filters, that is, FIR1 301, FIR2 303, FIR3 305, and FIR4 307. The PD also contains the third order product generation block 302, the fifth order product generation block 304, and the seventh order product generation block 306. The output signals from FIR filters are combined in the summation block 308. Coefficients for multiple FIR filters are updated by the MDS algorithm based on the adjacent channel power level or the ACPR as an evaluation function.

FIG 4. is a flow chart of a method for compensating for the PD in the DHMPA system of the present invention. It is the self- adaptation feedback part of the DHMPA system that utilizes the MDS algorithm. Operation of the predistortion compensating apparatus of FIG. 3 may be described with reference to this flow chart.

For purposes of simplicity, but not by way of limitation, WCDMA has been used as an example to illustrate the self-adaptation feedback part and the MDS algorithm. The present invention is by no means limited to WCDMA, since the present invention is standard and modulation agnostic. In WCDMA applications, 12 WCDMA channels are detected first by sweeping PLL in the feedback part (401) in order to search the activated and deactivated channels. Once channel locations are searched (402), the feedback part detects adjacent channel power level or ACPR (especially 5 MHz offset components) again by sweeping PLL (403). Then initialize predistortion and apply the MDS algorithm as follows:
At any iteration k, evaluate each coefficients set, then find the optimum set, **a**₀^{k}(404)
Rotation 405: rotate **a**₀^{k} and evaluate. If min{f(**a**ᵣᵢ^{k}), i=1,...,n}<f(**a**₀^{k}) is achieved (406), then go to the Expansion 407; or else go to Contraction 409.
Expansion 407: expand **a**ᵣᵢ^{k} and evaluate. If min{f(**a**ₑᵢ^{k}), i=1,...,n} < min{f(**a**ᵣᵢ^{k}), i=1,...,n} is achieved (408), then set **a**₀^{k} = **a**ₑᵢ^{k}; or else set **a**₀^{k} = **a**ᵣᵢ^{k} and go to (1)
Contraction 409: contract **a**₀^{k}, evaluate, and set **a**₀^{k} = **a**_{ci}^{k}, then go to (1)
   where, **a** is a vector of coefficients for multiple FIR filters, and f is the evaluation function, which is the adjacent channel power level or the ACPR.

The algorithm stops if the evaluation function is less than the minimum target value (410). This MDS algorithm is elegantly simple to be implemented.

In summary, the DHMPA system of the present invention could enhance the performance for the efficiency and linearity more effectively since the DHMPA system is able to implement CFR, DPD and adaptation algorithm in one digital processor, which subsequently saves hardware resources and processing time. The DHMPA system is also reconfigurable and field-programmable since the algorithms and power efficiency enhancing features can be adjusted like software in the digital processor at anytime.

Furthermore, since the DHMPA system accepts RF modulated signal as input, it is not necessary to use the coded I and Q channel signals in the baseband. Therefore, the performance of wireless base-station systems can be enhanced simply by replacing the existing PA modules with the DHMPA. The present invention allows a "plug and play" PA system solution such that existing base-station systems do not need to modify their structures and/or rebuild a new set of signal channels in order to benefit from high efficiency and high linearity PA system performance.

Moreover, the DHMPA system is agnostic to modulation schemes such as QPSK, QAM, OFDM, etc. in CDMA, GSM, WCDMA, CDMA2000, and wireless LAN systems. This means that the DHMPA system is capable of supporting multi-modulation schemes, multi-carriers and multi-channels. Other benefits of the DHMPA system includes correction of PA non-linearities in repeater or indoor coverage systems that do not have the necessary baseband signals information readily available.

Although the present invention has been described with reference to the preferred embodiments, it will be understood that the invention is not limited to the details described thereof. Various substitutions and modifications have been suggested in the foregoing description, and others will occur to those of ordinary skill in the art. Therefore, all such substitutions and modifications are intended to be embraced within the scope of the invention as defined in the appended claims.

### APPENDIX I

### Glossary of Terms

- ACLR: Adjacent Channel Leakage Ratio
- ACPR: Adjacent Channel Power Ratio
- ADC: Analog to Digital Converter
- AQDM: Analog Quadrature Demodulator
- AQM: Analog Quadrature Modulator
- AQDMC: Analog Quadrature Demodulator Corrector
- AQMC: Analog Quadrature Modulator Corrector
- BPF: Bandpass Filter
- CDMACode: Division Multiple Access
- CFR: Crest Factor Reduction
- DAC: Digital to Analog Converter
- DET: Detector
- DHMPA: Digital Hybrid Mode Power Amplifier
- DDC: Digital Down Converter
- DNC: Down Converter
- DPA: Doherty Power Amplifier
- DQDM: Digital Quadrature Demodulator
- DQM: Digital Quadrature Modulator
- DSP: Digital Signal Processing
- DUC: Digital Up Converter
- EER: Envelope Elimination and Restoration
- EF: Envelope Following
- ET: Envelope Tracking
- EVM: Error Vector Magnitude
- FFLPA: Feedforward Linear Power Amplifier
- FIR: Finite Impulse Response
- FPGA: Field-Programmable Gate Array
- GSM: Global System for Mobile communications
- I-Q: In-phase / Quadrature
- IF: Intermediate Frequency
- LINC: Linear Amplification using Nonlinear Components
- LO: Local Oscillator
- LPF: Low Pass Filter
- MCPA: Multi-Carrier Power Amplifier
- MDS: Multi-Directional Search
- OFDM: Orthogonal Frequency Division Multiplexing
- PA: Power Amplifier
- PAPR: Peak-to-Average Power Ratio
- PD: Digital Baseband Predistortion
- PLL: Phase Locked Loop
- QAM: Quadrature Amplitude Modulation
- QPSK: Quadrature Phase Shift Keying
- RF: Radio Frequency
- SAW: Surface Acoustic Wave Filter
- UMTS: Universal Mobile Telecommunications System
- UPC: Up Converter
- WCDMA: Wideband Code Division Multiple Access
- WLAN: Wireless Local Area Network

## Claims

1. A digital power amplifier system comprising:
a digital module for receiving at least one of RF and multi-channel digital inputs, the RF input (10) being received via an interface including a down converter (20) or an analog quadrature demodulator, the digital module comprising a digital field programmable gate array (515) and at least one of digital-to-analog converters (535), analog-to-digital converters (540), and a phase-locked loop (545), wherein the digital field programmable gate array (515) comprises a predistorter comprising a plurality of polynomial generation blocks;
a power amplifier portion responsive to signals representative of the output of the digital module; and
a feedback portion adapted to monitor signals representative of adjacent channel power for feeding back to the digital module signals representative of the output of the power amplifier portion, in response to which the digital module modifies its output using at least the polynomial generation blocks to reduce adjacent channel power,
wherein the digital power amplifier system is configured for base station applications and the digital field programmable gate array further comprises a digital quadrature demodulator when the RF input is used, a digital up-converter when the multi-channel digital input is used, a crest factor reduction, and a digital quadrature modulator, and
wherein the digital quadrature demodulator and the digital quadrature modulator can be replaced by an analog quadrature demodulator corrector and an analog quadrature modulator corrector respectively when the analog quadrature demodulator is used as the interface of the RF input.

2. The digital power amplifier system of claim 1 wherein the power amplifier part comprises at least one of an up-converter for real signal and an analog quadrature modulator for real and complex signals, a high power amplifier with multi-stage drive amplifiers, and a temperature sensor.

3. The digital power amplifier system of claim 1 wherein the feedback portion comprises at least one of a directional coupler, a mixer, a low pass filter, gain amplifiers, a band pass filter, and detectors.

4. The digital power amplifier system of claim 2 wherein the power amplifier portion uses efficiency boosting techniques comprising at least one of Doherty, Envelope Elimination and Restoration, Envelope Tracking, Envelope Following, or Linear amplification using Nonlinear Components.

5. The digital power amplifier system of claim 1, further comprising a digital-to-analog converter and up converter responsive to the digital portion for compensating in-band distortions resulting from the clipped signal at the output of the power amplifier portion caused by crest factor reduction.

6. The digital power amplifier system of claim 1 wherein the predistortion polynomial generation blocks are dynamically adjusted based on the monitored signals.

7. The digital power amplifier system of claim 1 wherein the feedback portion is adapted to monitor the signals representative of adjacent channel power, at least in part, by monitoring a variation of linearity in the output of the power amplifier portion.

8. The digital power amplifier system of claim 1 wherein the feedback portion is adapted to monitor the signals representative of adjacent channel power, at least in part, by monitoring an asymmetric distortion in the output of the power amplifier portion.

9. The digital power amplifier system of claim 1 further comprising a temperature sensor configured to monitor a temperature of the power amplifier portion, wherein the digital module controls a gate bias of the power amplifier portion based at least in part on the monitored temperature.

10. The digital power amplifier system of claim 1 wherein the predistorter does not receive in-phase or quadrature channel signals in a baseband.

11. The digital power amplifier system of claim 1 wherein the power amplifier is modulation agnostic.

## Patentansprüche

1. Digitales Leistungsverstärkersystem, das Folgendes umfasst:
ein digitales Modul zum Empfangen von wenigstens einem von digitalen RF- und Mehrkanal-Eingängen, wobei der RF-Eingang (10) über eine Schnittstelle mit einem Abwärtskonverter (20) oder einem analogen Quadraturdemodulator empfangen wird, wobei das digitale Modul ein digitales feldprogrammierbares Gate-Array (515) und wenigstens eines aus Digital-Analog-Konvertern (535), Analog-Digital-Konvertern (540) und einem Phasenregelkreis (545) umfasst, wobei das digitale feldprogrammierbare Gate-Array (515) einen Vorverzerrer umfasst, der mehrere Polynomerzeugungsblöcke umfasst;
einen Leistungsverstärkerteil, der auf Signale anspricht, die den Ausgang des digitalen Moduls repräsentieren; und
einen Feedback-Teil, ausgelegt zum Überwachen von Signalen, die Nachbarkanalleistung zum Zurückmelden zu den digitalen Modulsignalen repräsentieren, die den Ausgang des Leistungsverstärkerteils repräsentieren, als Reaktion auf die das digitale Modul seinen Ausgang mit wenigstens den Polynomerzeugungsblöcken modifiziert, um Nachbarkanalleistung zu reduzieren,
wobei das digitale Leistungsverstärkersystem für Basisstationsanwendungen konfiguriert ist und das digitale feldprogrammierbare Gate-Array ferner Folgendes umfasst: einen digitalen Quadraturdemodulator, wenn der RF-Eingang benutzt wird, einen digitalen Aufwärtswandler, wenn der digitale Mehrkanaleingang benutzt wird, einen Scheitelfaktorreduzierer und einen digitalen Quadraturmodulator, und
wobei der digitale Quadraturdemodulator und der digitale Quadraturmodulator durch einen analogen Quadraturdemodulator-Korrektor bzw. einen analogen Quadraturmodulator-Korrektor ersetzt werden können, wenn der analoge Quadraturdemodulator als Schnittstelle des RF-Eingangs benutzt wird.

2. Digitales Leistungsverstärkersystem nach Anspruch 1, wobei der Leistungsverstärkerteil einen Aufwärtskonverter für reale Signale und/oder einen analogen Quadraturmodulator für reale und komplexe Signale, einen Hochleistungsverstärker mit mehrstufigen Antriebsverstärkern und einen Temperatursensor umfasst.

3. Digitales Leistungsverstärkersystem nach Anspruch 1, wobei der Feedback-Teil wenigstens eines aus einem Richtungskoppler, einem Mixer, einem Tiefpassfilter, Gain-Verstärkern, einem Bandpassfilter und Detektoren umfasst.

4. Digitales Leistungsverstärkersystem nach Anspruch 2, wobei der Leistungsverstärkerteil Effizienz-Boosting-Techniken benutzt, umfassend wenigstens eines aus Doherty, Envelope Elimination und Restoration, Envelope Tracking, Envelope Following oder Linearverstärkung mit nichtlinearen Komponenten.

5. Digitales Leistungsverstärkersystem nach Anspruch 1, das ferner einen Digital-Analog-Konverter und einen Aufwärtskonverter umfasst, der auf den digitalen Teil anspricht, zum Kompensieren von bandinternen Verzerrungen, die von dem limitierten Signal am Ausgang des Leistungsverstärkerteils resultieren, verursacht durch Scheitelfaktorreduktion.

6. Digitales Leistungsverstärkersystem nach Anspruch 1, wobei die Vorverzerrungs-Polynomerzeugungsblöcke auf der Basis der überwachten Signale dynamisch justiert werden.

7. Digitales Leistungsverstärkersystem nach Anspruch 1, wobei der Feedback-Teil zum Überwachen der Signale ausgelegt ist, die Nachbarkanalleistung repräsentieren, wenigstens teilweise durch Überwachen einer Linearitätsvariation im Ausgang des Leistungsverstärkerteils.

8. Digitales Leistungsverstärkersystem nach Anspruch 1, wobei der Feedback-Teil zum Überwachen der Signale ausgelegt ist, die Nachbarkanalleistung repräsentieren, wenigstens teilweise durch Überwachen einer asymmetrischen Verzerrung im Ausgang des Leistungsverstärkerteils.

9. Digitales Leistungsverstärkersystem nach Anspruch 1, das ferner einen Temperatursensor umfasst, konfiguriert zum Überwachen einer Temperatur des Leistungsverstärkerteils, wobei das digitale Modul einen Gate-Bias des Leistungsverstärkerteils wenigstens teilweise auf der Basis der überwachten Temperatur regelt.

10. Digitales Leistungsverstärkersystem nach Anspruch 1, wobei der Vorverzerrer keine phasengleichen oder Quadratur-Kanalsignale in einem Basisband empfängt.

11. Digitales Leistungsverstärkersystem nach Anspruch 1, wobei der Leistungsverstärker modulationsagnostisch ist.

## Revendications

1. Système d'amplificateur de puissance numérique comprenant :
un module numérique pour recevoir au moins une entrée parmi des entrées numériques de canaux multiples et RF, l'entrée RF (10) étant reçue via une interface incluant un convertisseur abaisseur (20) ou un démodulateur de quadrature analogique, le module numérique comprenant un réseau prédiffusé programmable par l'utilisateur numérique (515) et au moins un élément parmi des convertisseurs numériques/analogiques (535), des convertisseurs analogiques/numériques (540), et une boucle à phase asservie (545), dans lequel le réseau prédiffusé programmable par l'utilisateur numérique (515) comprend un dispositif de prédistorsion comprenant une pluralité de blocs de génération polynomiale ;
une portion amplificateur de puissance réagissant à des signaux représentatifs de la sortie du module numérique ; et
une portion rétroaction conçue pour surveiller des signaux représentatifs d'une puissance de canal adjacent pour amener en retour vers le module numérique des signaux représentatifs de la sortie de la portion amplificateur de puissance, en réponse à quoi le module numérique modifie sa sortie en utilisant au moins les blocs de génération polynomiale afin de réduire une puissance de canal adjacent,
dans lequel le système d'amplificateur de puissance numérique est configuré pour des applications de station de base et le réseau prédiffusé programmable par l'utilisateur numérique comprend en outre un démodulateur de quadrature numérique lorsque l'entrée RF est utilisée, un convertisseur élévateur numérique lorsque l'entrée numérique de canaux multiples est utilisée, une réduction de facteur de crête, et un modulateur de quadrature numérique, et
dans lequel le démodulateur de quadrature numérique et le modulateur de quadrature numérique peuvent être remplacés par un correcteur de démodulateur de quadrature analogique et un correcteur de modulateur de quadrature analogique respectivement lorsque le démodulateur de quadrature analogique est utilisé à titre d'interface de l'entrée RF.

2. Système d'amplificateur de puissance numérique de la revendication 1, la partie amplificateur de puissance comprenant au moins un élément parmi un convertisseur élévateur pour un signal réel et un modulateur de quadrature analogique pour des signaux réels et complexes, un amplificateur de haute puissance avec des amplificateurs de commande à étages multiples, et un capteur de température.

3. Système d'amplificateur de puissance numérique de la revendication 1, la portion rétroaction comprenant au moins un élément parmi un coupleur directionnel, un mélangeur, un filtre passe-bas, des amplificateurs de gain, un filtre de bande passante et des détecteurs.

4. Système d'amplificateur de puissance numérique de la revendication 2, la portion amplificateur de puissance utilisant des techniques de renforcement de l'efficacité comprenant au moins un élément parmi Doherty, Elimination et Restauration d'Enveloppe, Poursuite d'Enveloppe, Suivi d'Enveloppe, ou amplification linéaire en utilisant des composants non linéaires.

5. Système d'amplificateur de puissance numérique de la revendication 1, comprenant en outre un convertisseur numérique/analogique et un convertisseur élévateur réagissant à la portion numérique pour compenser des distorsions en bande qui résultent du signal écrêté au niveau de la sortie de la portion amplificateur de puissance causées par la réduction du facteur de crête.

6. Système d'amplificateur de puissance numérique de la revendication 1, les blocs de génération polynomiale de prédistorsion étant ajustés dynamiquement sur la base des signaux surveillés.

7. Système d'amplificateur de puissance numérique de la revendication 1, la portion rétroaction étant conçue pour surveiller les signaux représentatifs d'une puissance de canal adjacent, au moins en partie, en surveillant une variation de linéarité dans la sortie de la portion amplificateur de puissance.

8. Système d'amplificateur de puissance numérique de la revendication 1, la portion rétroaction étant conçue pour surveiller les signaux représentatifs d'une puissance de canal adjacent, au moins en partie, en surveillant une distorsion asymétrique dans la sortie de la portion amplificateur de puissance.

9. Système d'amplificateur de puissance numérique de la revendication 1, comprenant en outre un capteur de température configuré de façon à surveiller une température de la portion amplificateur de puissance, dans lequel le module numérique contrôle une polarisation de porte de la portion amplificateur de puissance sur la base, au moins en partie, de la température surveillée.

10. Système d'amplificateur de puissance numérique de la revendication 1, le dispositif de prédistorsion ne recevant pas des signaux de canal en quadrature ou en phase dans une bande de base.

11. Système d'amplificateur de puissance numérique de la revendication 1, l'amplificateur de puissance étant agnostique à la modulation.
